# EUROPEAN PATENT SPECIFICATION

(11) **EP 4 177 948 B1**
(45) Date of publication and mention of the grant of the patent: **04.11.2026**
(21) Application number: 21952106.9
(22) Date of filing: 27.08.2021
(51) Int. Cl.: H10H 29/24, H10H 20/841, H10H 20/01

(54) **BACKLIGHT-TYPE MINI LED CHIP AND MANUFACTURING METHOD THEREFOR**
MINI-LED-CHIP VOM HINTERGRUNDBELEUCHTUNGSTYP UND HERSTELLUNGSVERFAHREN DAFÜR
PUCE MINILED DU TYPE POUR RÉTROÉCLAIRAGE ET SON PROCÉDÉ DE FABRICATION

(30) Priority: 11.08.2021 CN 202110919850
(43) Date of publication of application: 10.05.2023
(73) Proprietor: Fuzhou China Prima Optoelectronics Co., Ltd., Fuzhou City 350000 (CN)
(72) Inventor: WU, Yongsheng, Fuzhou Fujian 350109 (CN); ZHANG, Fan, Fuzhou Fujian 350109 (CN); QI, Jiapeng, Fuzhou Fujian 350109 (CN); ZHANG, Tingfang, Fuzhou Fujian 350109 (CN)
(74) Representative: Zhu, Puxing
(86) International application number: PCT/CN2021/114878
(87) International publication number: WO 2023/015617

(56) References cited:
- WO-A1-2014/108782
- WO-A1-2017/171812
- CN-A- 101 572 286
- CN-A- 110 676 358
- CN-A- 111 624 817
- CN-A- 111 883 626
- CN-A- 112 882 287
- CN-A- 112 882 287
- US-A1- 2004 065 886
- US-A1- 2010 226 404
- US-A1- 2012 112 218
- US-A1- 2012 112 218
- US-A1- 2017 250 315
- US-A1- 2018 059 303

## Description

### Technical Field

The invention relates to the field of LED fabrication, in particular to a backlight-type Mini LED chip and a fabrication method therefor.

### Description of Related Art

At present, direct-type Mini LED backlight can effectively improve the color performance and contrast performance of LCDs, and has become the main form of LED backlight in the future.

However, the direct-type LED backlight form has different requirements for LED chips. Existing backlight-type Mini LEDs emit light completely from the back or the side, so when they are used for direct-type Mini LED backlight, the problems of difficult light shape control, complex module matching and debugging and unsatisfying display effect will be caused.

Document CN 112 882 287 A discloses a backlight module in which a first electrode is laminated on a second surface and a quantum line array, and a grating is set on one side surface of a second buffer layer away from a substrate layer.

### Brief Summary of the Invention

The technical issue to be settled by the invention is to provide a plurality of backlight-type Mini LED chips and a fabrication method therefor, which can improve the control effect and display effect of backlight-type Mini LED chips.

One technical solution adopted by the invention to settle the above technical issue is as follows:
A fabrication method as recited in claim 1.

Another technical solution adopted by the invention to settle the above technical issue is as follows:

A plurality of backlight-type Mini LED chips as recited in claim 7.

The invention has the following beneficial effects: according to a preset arrangement of Mini LED chips, a grating in a shape corresponding to the preset arrangement is etched on a backlight reflective layer of each chip, such that the light shape of the Mini LED chips can be controlled; the shape of the grating corresponds to the preset arrangement of the chips, such that the chips can be divided into more regions, which is equivalent to increasing the arrangement density of the chips, the visual resolution experience is improved, and the resolution perceived by human eyes is increased, thus improving the display effect of the chips; and the width of the grating can be adjusted to change the ratio of vertical emergent light and lateral emergent light of the chip, so as to adjust the angle and intensity of emergent light of the chip, such that the control effect and display effect of the Mini LED chips are further improved.

### Brief Description of the Several Views of Drawings

FIG 1 is a flow diagram of a fabrication method for a backlight-type Mini LED chip according to one embodiment of the invention;
FIG 2 is a structural diagram of a backlight-type Mini LED chip according to one embodiment of the invention;
FIG 3 is a schematic diagram of the backlight-type Mini LED chips which are arranged in a matrix and provided with cross-shaped gratings according to one embodiment of the invention;
FIG 4 is a schematic diagram of the backlight-type Mini LED chips which are arranged in a matrix and provided with square gratings according to one embodiment of the invention;
FIG 5 is a schematic diagram of the backlight-type Mini LED chips which are arranged in a rhombic shape and provided with X-shaped gratings according to one embodiment of the invention;

### Reference signs:

1, backlight reflective film; 2, substrate layer; 3, flip chip; 4, chip weld-bonding electrode; 5, grating; 6, chip gap lateral emergent region.

### Detailed Description of the Invention

The technical contents, purposes and effects of the invention will be described in detail below in conjunction with embodiments and accompanying drawings.

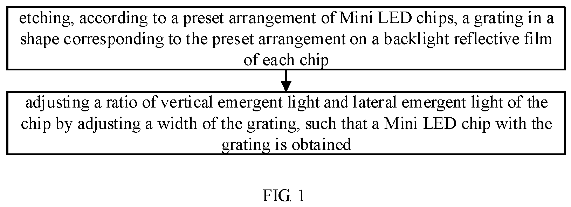

Referring to FIG 1, and FIG 3-FIG 5, this embodiment of the invention provides a fabrication method for a backlight-type Mini LED chip, comprising the following steps:
Etching, according to a preset arrangement of Mini LED chips, a grating in a shape corresponding to the preset arrangement on a backlight reflective film of each chip; and
Adjusting the ratio of vertical emergent light and lateral emergent light of the chip by adjusting the width of the grating, such that a Mini LED chip with the grating is obtained.

From the above description, the invention has the following beneficial effects: according to a preset arrangement of Mini LED chips, a grating in a shape corresponding to the preset arrangement is etched on a backlight reflective layer of each chip, such that the light shape of the Mini LED chips can be controlled; the shape of the grating corresponds to the preset arrangement of the chips, such that the chips can be divided into more regions, which is equivalent to increasing the arrangement density of the chips, the visual resolution experience is improved, and the resolution perceived by human eyes is increased, thus improving the display effect of the chips; and the width of the grating can be adjusted to change the ratio of vertical emergent light and lateral emergent light of the chip, so as to adjust the angle and intensity of emergent light of the chip, such that the control effect and display effect of the Mini LED chips are further improved.

Further, the grating in the shape corresponding to the preset arrangement comprises:
If the preset arrangement is a rectangular matrix, the grating is a cross line which is perpendicular to four edges of the chip and has an intersection point being the central point of the chip; or, the grating is a square grating with the central point of the chip as a center;
If the preset arrangement is a rhombic matrix, the grating is two diagonal lines of the chip.

From the above description, if the preset arrangement is a rectangular matrix, the grating is a cross line which is perpendicular to four edges of the chip and has an intersection point being the central point of the chip; or, the grating is a square grating with the central point of the chip as a center; if the preset arrangement is a rhombic matrix, the grating is two diagonal lines of the chip. In this way, the partition in the chips is kept horizontally consistent with the arrangement of the chips, and after the grating is etched, the visual resolution experience is improved, which is equivalent to improving the arrangement density of the chip, thus increasing the resolution visually perceived by human eyes.

Further, adjusting the ratio of vertical emergent light and lateral emergent light of the chip by adjusting the width of the grating comprises:
Determining whether the lateral emergent light of the chip is more than the vertical emergent light of the chip; if so, increasing the width of the grating; otherwise, decreasing the width of the grating.

From the above description, when lateral emergent light of the chip is more than vertical emergent light of the chip, that is, when the brightness above the chip is relatively low, the width of the grating can be increased, which is especially suitable for high-density and high-resolution backlight; when lateral emergent light of the chip is less than vertical emergent light of the chip, the width of the grating of the chip can be decreased, such that the ratio of lateral light to vertical light is adjusted to make the overall emergent light uniform.

Further, etching, according to a preset arrangement of Mini LED chips, a grating in a shape corresponding to the preset arrangement on a backlight reflective film of each chip comprises:
Growing a GaN-based epitaxial wafer at one end of a substrate layer;
Machining a flip chip at an end, away from the substrate layer, of the GaN-based epitaxial wafer to obtain a wafer;
Fine polishing an end, away from the GaN-based epitaxial wafer, of the substrate layer of the wafer, and performing alignment on a photomask and an existing pattern of the fine polished wafer through a back alignment method;
Performing exposure and development on the wafer subjected to alignment, and transferring, with a photoresist, a grating pattern in the shape corresponding to the preset arrangement to the end, away from the GaN-based epitaxial wafer, of the substrate layer; and
Performing metal sputtering evaporation on the end, away from the GaN-based epitaxial wafer, of the substrate layer according to a preset material sequence, and stripping metal at a position corresponding to the grating pattern to obtain an etched backlight reflective film.

From the above description, considering that the electrode on the front side of horizontal chips faces upwards and will shield part of light and reduce the luminous efficiency, the flip chip is machined at the end, away from the substrate layer, of the epitaxial wafer to improve the luminous efficiency of the chip; and accurate alignment of the wafer can be realized through the lithographic back alignment method, and grating lithography on the backlight reflective film can be realized through exposure, development, transfer of the gating pattern, metal evaporation of the backlight reflective film and stripping of metal at the position corresponding to the grating, and thus, the display efficiency is improved.

Further, the preset material sequence is sequentially nickel, silver, nickel, titanium-tungsten, nickel, and titanium-tungsten.

From the above description, metal evaporation is performed according to the sequence of nickel, silver, nickel, titanium-tungsten, nickel, and titanium-tungsten, and the grating is reflective, such that light attenuation of the chip will not be caused, thus improving the display efficiency.

Further, performing alignment on a photomask and an existing pattern of the fine polished wafer through a back alignment method comprises:
Reserving a metal alignment pattern, which is seen from a back side of the wafer by reflection, on a front side of the wafer, and performing alignment on the photomask and the existing pattern of the wafer.

From the above description, because the metal alignment pattern reserved on the front side of the wafer can be seen from the back side of the wafer through light reflection, back alignment of the photomask and the existing pattern of the wafer can be performed, which is beneficial to subsequent lithography of the grating.

Further, before obtaining the Mini LED chip with the grating, the fabrication method comprises:
Cutting the chip according to a preset interval, and arranging chips obtained after cutting according to the preset arrangement.

From the above description, the chip is cut according to a preset interval, chips obtained after cutting are arranged according to the preset arrangement, and gaps between the chips form lateral emergent regions, which can improve the display efficiency in conjunction with vertical emergent light of the chips.

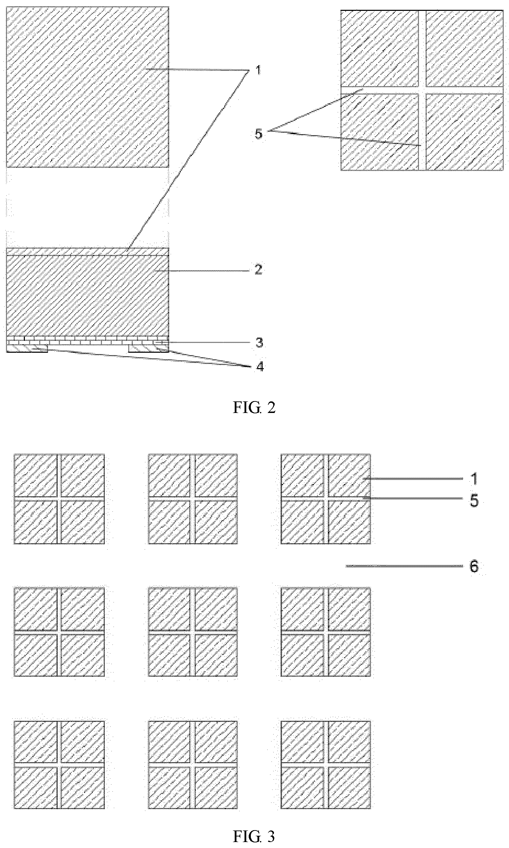

Referring to FIG 2, another embodiment of the invention provides a backlight-type Mini LED chip, comprising a back light-shield reflective layer, a substrate layer, and a flip chip, wherein:
The back light-shield reflective layer is located at one end of the substrate layer;
The flip chip is located at an end, away from the back light-shield reflective layer, of the substrate layer;
The back light-shield reflective layer comprises a grating in a shape corresponding to a preset arrangement of Mini LED chips.

From the above description, according to a preset arrangement of Mini LED chips, a grating in a shape corresponding to the preset arrangement is etched on a backlight reflective layer of each chip, such that the light shape of the Mini LED chips can be controlled; the shape of the grating corresponds to the preset arrangement of the chips, such that the chips can be divided into more regions, which is equivalent to increasing the arrangement density of the chips, the visual resolution experience is improved, and the resolution perceived by human eyes is increased, thus improving the display effect of the chips; and the width of the grating can be adjusted to change the ratio of vertical emergent light and lateral emergent light of the chip, so as to adjust the angle and intensity of emergent light of the chip, such that the control effect and display effect of the Mini LED chips are further improved.

Further, the preset arrangement of the Mini LED chips is a rectangular matrix or a rhombic matrix, and an interval between the Mini LED chips is 100 µm-15000 µm.

From the above description, the chip is cut according to a preset interval, chips obtained after cutting are arranged according to the preset arrangement, and gaps between the chips form lateral emergent regions, which can improve the display efficiency in conjunction with vertical emergent light of the chips.

Further, if the preset arrangement of the Mini LED chips is the rectangular matrix, the grating is a cross line which is perpendicular to four edges of the chip and has an intersection point being the central point of the chip; or, the grating is a square grating with the central point of the chip as a center;
If the preset arrangement of the Mini LED chips is the rhombic matrix, the grating is two diagonal lines of the chip;
The width of the grating is 2 µm-200 µm.

From the above description, if the preset arrangement of the chips is a rectangular matrix, the grating is a cross line which is perpendicular to four edges of the chip and has an intersection point being the central point of the chip; or, the grating is a square grating with the central point of the chip as a center; if the preset arrangement is a rhombic matrix, the grating is two diagonal lines of the chip. In this way, the partition in the chips is kept horizontally consistent with the arrangement of the chips, and after the grating is etched, the visual resolution experience is improved, which is equivalent to improving the arrangement density of the chip, thus increasing the resolution visually perceived by human eyes.

### Embodiment 1

Referring to FIG 1, and FIG 3-FIG 5, a fabrication method for a backlight-type Mini LED chip comprises the following steps:
S1: etching, according to a preset arrangement of Mini LED chips, a grating 5 in a shape corresponding to the preset arrangement on a backlight reflective film 1 of each chip;
S11: growing a GaN-based epitaxial wafer at one end of a substrate layer 2.
S12: machining a flip chip 3 at an end, away from the substrate layer 2, of the GaN-based epitaxial wafer to obtain a wafer, wherein an end, away from the epitaxial wafer, of the flip chip is provided with two chip electrodes 4;
S13: fine polishing an end, away from the GaN-based epitaxial wafer, of the substrate layer 2, and performing alignment on a photomask and an existing pattern of the fine polished wafer through a back alignment method;

Wherein, performing alignment on a photomask and an existing pattern of the fine polished wafer through a back alignment method comprises:
Reserving a metal alignment pattern, which is seen from a back side of the wafer by reflection, on a front side of the wafer, and performing alignment on the photomask and the existing pattern of the wafer;
S14: performing exposure and development on the wafer subjected to alignment, and transferring, with a photoresist, a grating pattern in the shape corresponding to the preset arrangement to the end, away from the GaN-based epitaxial wafer, of the substrate layer;
S15: performing metal sputtering evaporation on the end, away from the GaN-based epitaxial wafer, of the substrate layer according to a preset material sequence, and stripping metal at a position corresponding to the grating pattern to obtain an etched backlight reflective film 1, wherein the preset material sequence is sequentially nickel, silver, nickel, titanium-tungsten, nickel, and titanium-tungsten;

Wherein, the grating 5 in the shape corresponding to the preset arrangement comprises:
If the preset arrangement is a rectangular matrix, the grating is a cross line which is perpendicular to four edges of the chip and has an intersection point being the central point of the chip; or, the grating is a square grating with the central point of the chip as a center;
If the preset arrangement is a rhombic matrix, the grating is two diagonal lines of the chip.

Specifically, referring to FIG 3 to FIG 5, when the preset arrangement is a matrix, the grating is cross-shaped or square, so the partition in the chips is kept horizontally consistent with the arrangement of the chips, thus improving the visual resolution experience after partition; and with the increase of regions, the arrangement density of rectangular pixels is increased. Light can be emitted from gaps of the grating and two sides of the chip, so compared with chips without gratings, light can be emitted from more portions. When the preset arrangement is rhombic, the grating is X-shaped, which is consistent with the arrangement direction of the chips, so light can also be emitted from more portions; and original light-emitting regions are further divided, such that the arrangement density of rhombic pixels is increased. Such density increase effect is realized in one backlight chip;
S2: changing the ratio of vertical emergent light to lateral emergent light of the chip by adjusting the width of the grating, such that a Mini LED chip with the grating is obtained;
S21: determining whether the lateral emergent light of the chip is more than the vertical emergent light of the chip; if so, increasing the width of the grating; otherwise, decreasing the width of the grating;
Specifically, when lateral emergent light of the chip is more than vertical emergent light of the chip and the brightness above the chip is relatively low, the width of the grating can be increased, which is especially suitable for high-density and high-resolution backlight. When lateral emergent light of the chip is less than vertical emergent light of the chip, the width of the grating of the chip can be decreased, such that the overall emergent light can be adjusted to be uniform. The overall light intensity of the chip is constant, and with the increase of the width of the grating, the lateral light will become less, and the front light will become more, so the ratio of lateral light to front light can be adjusted by changing the width of the grating;
S22: cutting the chip according to a preset interval, and arranging chips obtained after cutting according to the preset arrangement to obtain chip gap lateral emergent regions 6.

According to the Mini LED chip of such a structure, the size of an opening of the grating can be adjusted by controlling the design size of the photomask, so as to adjust the ratio of front emergent light and lateral emergent light of the chip, and thus, the shape, scope and intensity distribution of emergent light are adjusted, the chip arrangement on a substrate can be optimized, and the demand for optical elements such as a light guide plate and a diffuser plate on the substrate can be reduced. The light-emitting scope of the Mini LED array processed by the grating is further partitioned, so the resolution visually perceived by human eyes is better than that of chips without gratings.

### Embodiment 2

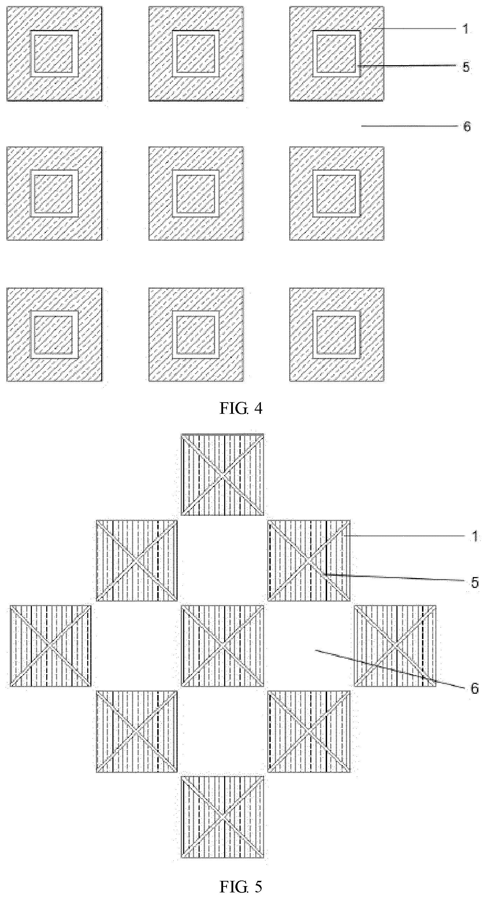

Referring to FIG 3 and FIG 4, this embodiment provides a chip fabrication method in a case where the preset arrangement of Mini LED chips is a rectangular matrix, which comprises:
1.1: machining a 200*200 µm flip chip based on a GaN-based epitaxial wafer, wherein the flip chip is provided with chip electrodes to be bonded with a substrate, and the chip structure and an epitaxial layer are located on a front side of an AI₂O₃ substrate layer;
2.1: thinning the prepared wafer to 150 µm, and fine polishing a back side of the substrate layer to reduce the roughness to Ra<0.5 µm;
3.1: performing lithography on the back side of the fine polished substrate, reserving a GaN alignment pattern and a metal alignment pattern on a front side of the wafer, wherein due to the fact that metal can reflect light, the metal alignment patter can be seen from the back side to realize back alignment; completing alignment of a photomask and an existing pattern of the wafer through a back alignment method, then performing exposure and development, and transferring, with a photoresist, a pre-designed grating pattern to the back side of the substrate, wherein other chip structures except a back light-shield reflective layer are basically identical with those of the flip chip and have been machined in step 1.1;
4.1: performing metal sputtering evaporation in sequence by means of metal sputtering equipment, wherein materials and the corresponding sequence are as follows: nickel 1 nm, silver 200 nm, nickel 50 nm, titanium-tungsten 200 nm, nickel 60 nm, and titanium-tungsten 200 nm;
5.1: stripping metal at a grating position reserved in Step 3.1 through a metal stripping process;
6.1: cutting the chip according to a preset interval by means of a diamond abrasive wheel cutting machine, and separating chips obtained after cutting;
7.1: if an arrangement matrix of backlight is a square or rectangular matrix, preparing a preset grating which is a cross line perpendicular to four edges of the chip and having an intersection point being the central point of the chip, or is a square grating with the central point of the chip as a center; arranging chips with the gratings according to a certain interval, and then welding the chips on the substrate in batches to make a backlight module, wherein the interval is determined according to the brightness required by the backlight and the design of a light guide plate, and is generally 100 µm-15000 µm.

### Embodiment 3

Referring to FIG 5, this embodiment provides a chip fabrication method in a case where the preset arrangement of Mini LED chips is a rhombic matrix, which comprises:
1.2: machining a 300*300 µm flip chip based on a GaN-based epitaxial wafer, wherein the flip chip is provided with chip electrodes to be bonded with a substrate, and the chip structure and an epitaxial layer are located on a front side of an AI₂O₃ substrate layer;
2.2: thinning the prepared wafer to 200 µm, and fine polishing a back side of the substrate layer to reduce the roughness to Ra<0.3 µm;
3.2: evaporating a distributed Bragg reflector coating group by means of an RPD optical coating machine, wherein a reflector coating formed by SiO and TiO alternately or SiO and HfO alternately, and 47 coatings or 23 pairs of coatings are evaporated in total, and the effective reflection wavelength is 380 nm-780 nm;
4.2: performing lithography on a back side of the fine polished substrate, completing alignment of a photomask and an existing pattern of the wafer through a back alignment method, then performing exposure and development, and transferring, with a photoresist, a pre-designed grating pattern to the back side of the substrate;
5.2: according to a reserved grating position, etching away, by means of ICP etching equipment, the distributed Bragg reflector coatings in the grating pattern, and removing the photoresist after etching is completed;
6.2: cutting the chip with a 1064 nm laser which penetrates through the Bragg reflector coatings and is focused in the AI₂O₃ substrate, and separating chips obtained after cutting according to a preset interval;
7.2: if an arrangement matrix of backlight is a rhombic array, preparing a preset grating which is a diagonal lines of the chip and has a width of 2 µm-200 µm; arranging chips with the gratings according to a certain interval, and then welding the chips on the substrate in batches to make a backlight module, wherein the interval is generally 100 µm-15000 µm, which is determined according to the brightness required by the backlight and the design of a light guide plate,

### Embodiment 4

Referring to FIG 2 to FIG 5, a backlight-type Mini LED chip comprises a back light-shield reflective layer, a substrate layer and a flip chip, wherein:
The back light-shield reflective layer is located at one end of the substrate layer;
The flip chip is located at an end, away from the back light-shield reflective layer, of the substrate layer;
The back light-shield reflective layer comprises a grating in a shape corresponding to a preset arrangement of Mini LED chips.

In this embodiment, the preset arrangement of the Mini LED chips is a rectangular matrix or a rhombic matrix, and an interval between the Mini LED chips is 100 µm-15000 µm.

If the preset arrangement of the Mini LED chips is the rectangular matrix, the grating is a cross line which is perpendicular to four edges of the chip and has an intersection point being the central point of the chip; or, the grating is a square grating with the central point of the chip as a center;
If the preset arrangement of the Mini LED chips is the rhombic matrix, the grating is two diagonal lines of the chip;
The width of the grating is 2 µm-200 µm.

According to the backlight-type Mini LED chip and the fabrication therefor, according to a preset arrangement of Mini LED chips, a grating in a shape corresponding to the preset arrangement is etched on a backlight reflective layer of each chip, such that the light shape of the Mini LED chips can be controlled; the shape of the grating corresponds to the preset arrangement of the chips, such that the chips can be divided into more regions, which is equivalent to increasing the arrangement density of the chips, the visual resolution experience is improved, and the resolution perceived by human eyes is increased, thus improving the display effect of the chips; and the width of the grating can be adjusted to change the ratio of vertical emergent light and lateral emergent light of the chip, so as to adjust the angle and intensity of emergent light of the chip, such that the control effect and display effect of the Mini LED chips are further improved. Thus, the size of an opening of the grating of the Mini LED chip can be adjusted by controlling the design size of the photomask, so as to adjust the ratio of front emergent light and lateral emergent light of the chip, and thus, the shape, scope and intensity distribution of emergent light are adjusted.

The above description is merely used to explain the embodiments of the invention, and is not intended to limit the patent scope of the invention. The invention is defined by the appended claims.

## Claims

1. A fabrication method for a plurality of backlight-type Mini LED chips, wherein the plurality of backlight-type Mini LED chips has a preset arrangement of Mini LED chips chosen between a rectangular matrix and a rhombic matrix: wherein the method comprises:
etching, according to the preset arrangement of Mini LED chips, a grating (5) in a shape corresponding to the preset arrangement on a backlight reflective film (1) of each chip; wherein, the grating (5) in the shape corresponding to the preset arrangement comprises: if the preset arrangement is a rectangular matrix, the grating (5) is a cross line which is perpendicular to four edges of the chip and has an intersection point being a central point of the chip; or, the grating (5) is a square grating with the central point of the chip as a center; if the preset arrangement is a rhombic matrix, the grating (5) is two diagonal lines of the chip, and
adjusting a ratio of vertical emergent light and lateral emergent light of said each chip by adjusting a width of the grating (5), such that a Mini LED chip with the grating is obtained.

2. The fabrication method for a plurality of backlight-type Mini LED chips according to Claim 1, wherein adjusting a ratio of vertical emergent light and lateral emergent light of the chip by adjusting a width of the grating (5) comprises:
determining whether the lateral emergent light of the chip is more than the vertical emergent light of the chip; if so, increasing the width of the grating (5); otherwise, decreasing the width of the grating (5).

3. The fabrication method for a plurality of backlight-type Mini LED chips according to Claim 1, wherein etching, according to a preset arrangement of Mini LED chips, a grating (5) in a shape corresponding to the preset arrangement on a backlight reflective film (1) of each chip comprises:
growing a GaN-based epitaxial wafer at one end of a substrate layer (2);
machining a flip chip (3) at an end, away from the substrate layer (2), of the GaN-based epitaxial wafer to obtain a wafer;
fine polishing an end, away from the GaN-based epitaxial wafer, of the substrate layer (2) of the wafer, and performing alignment on a photomask and an existing pattern of the fine polished wafer through a back alignment method;
performing exposure and development on the wafer subjected to alignment, and transferring, with a photoresist, a grating pattern in the shape corresponding to the preset arrangement to the end, away from the GaN-based epitaxial wafer, of the substrate layer (2); and
performing metal sputtering evaporation on the end, away from the GaN-based epitaxial wafer, of the substrate layer (2) according to a preset material sequence, and stripping metal at a position corresponding to the grating pattern to obtain an etched backlight reflective film (1).

4. The fabrication method for a plurality of backlight-type Mini LED chips according to Claim 3, wherein the preset material sequence is sequentially nickel, silver, nickel, titanium-tungsten, nickel, and titanium-tungsten.

5. The fabrication method for a plurality of backlight-type Mini LED chips according to Claim 3, wherein performing alignment on a photomask and an existing pattern of the fine polished wafer through a back alignment method comprises:
reserving a metal alignment pattern, which is seen from a back side of the wafer by reflection, on a front side of the wafer, and performing alignment on the photomask and the existing pattern of the wafer.

6. The fabrication method for a plurality of backlight-type Mini LED chips according to Claim 1, wherein before obtaining the Mini LED chip with the grating (5), the fabrication method comprises:
cutting the chip according to a preset interval, and arranging chips obtained after cutting according to the preset arrangement.

7. A plurality of backlight-type Mini LED chips having a preset arrangement of Mini LED chips chosen between a rectangular matrix and a rhombic matrix, wherein each backlight-type Mini LED chip of the plurality of backlight-type Mini LED chips comprises a back light-shield reflective layer, a substrate layer (2), and a flip chip (3), wherein:
the back light-shield reflective layer is located at one end of the substrate layer (2); the flip chip (3) is located at an end, away from the back light-shield reflective layer, of the substrate layer (2);
the back light-shield reflective layer comprises a grating (5) ,
wherein if the preset arrangement of the Mini LED chips is the rectangular matrix, the grating (5) is a cross line which is perpendicular to four edges of the chip and has an intersection point being a central point of the chip; or, the grating (5) is a square grating with the central point of the chip as a center;
if the preset arrangement of the Mini LED chips is the rhombic matrix, the grating (5) is two diagonal lines of the chip; and wherein
an interval between the Mini LED chips is 100 µm-15000 µm; and
a width of the grating (5) is 2 µm-200 µm .

## Patentansprüche

1. Verfahren zur Herstellung einer Vielzahl von Mini-LED-Chips für Hintergrundbeleuchtungen, wobei die Vielzahl von Mini-LED-Chips für Hintergrundbeleuchtungen eine vorgegebene Anordnung von Mini-LED-Chips aufweist, die zwischen einer rechteckigen Matrix und einer rautenförmigen Matrix gewählt wird; wobei das Verfahren umfasst:
Ätzen eines Gitters (5) in einer der vorgegebenen Anordnung der Mini-LED-Chips entsprechenden Form auf eine reflektierende Hintergrundbeleuchtungsschicht (1) jedes Chips; wobei das Gitter (5) in der der vorgegebenen Anordnung entsprechenden Form umfasst: wenn die vorgegebene Anordnung eine rechteckige Matrix ist, ist das Gitter (5) eine Kreuzlinie, die senkrecht zu den vier Kanten des Chips verläuft und einen Schnittpunkt aufweist, der den Mittelpunkt des Chips bildet; oder ist das Gitter (5) ein quadratisches Gitter mit dem Mittelpunkt des Chips als Zentrum; wenn die vorgegebene Anordnung eine rhombische Matrix ist, besteht das Gitter (5) aus zwei Diagonalen des Chips,
und Anpassung des Verhältnisses von vertikalem und seitlichem Lichtaustritt jedes dieser Chips durch Anpassung der Breite des Gitters (5), sodass ein Mini-LED-Chip mit dem Gitter erhalten wird.

2. Herstellungsverfahren für eine Vielzahl von Mini-LED-Chips vom Hintergrundbeleuchtungstyp gemäß Anspruch 1, wobei das Einstellen eines Verhältnisses von vertikal austretendem Licht und seitlich austretendem Licht des Chips durch Einstellen einer Breite des Gitters (5) Folgendes umfasst:
Feststellen, ob das seitlich austretende Licht des Chips stärker ist als das vertikal austretende Licht des Chips; falls ja, Vergrößern der Breite des Gitters (5); andernfalls Verkleinern der Breite des Gitters (5).

3. Herstellungsverfahren für eine Vielzahl von Mini-LED-Chips vom Hintergrundbeleuchtungstyp gemäß Anspruch 1, wobei das Ätzen eines Gitters (5) in einer der vorgegebenen Anordnung der Mini-LED-Chips entsprechenden Form auf eine reflektierende Hintergrundbeleuchtungsschicht (1) jedes Chips gemäß einer vorgegebenen Anordnung der Mini-LED-Chips Folgendes umfasst:
Aufwachsen eines epitaktischen Wafers auf GaN-Basis an einem Ende einer Substratschicht (2);
Bearbeitung eines Flip-Chips (3) an einem von der Substratschicht (2) abgewandten Ende des epitaktischen Wafers auf GaN-Basis, um einen Wafer zu erhalten;
Feinpolieren eines Endes der Substratschicht (2) des Wafers, das vom GaN-basierten Epitaxiewafer abgewandt ist, und Durchführen einer Ausrichtung auf eine Fotomaske und ein vorhandenes Muster des feinpolierten Wafers mittels eines Rückseitenausrichtungsverfahrens;
Durchführen der Belichtung und Entwicklung auf dem ausgerichteten Wafer sowie Übertragen eines Gittermusters in der Form, die der vorgegebenen Anordnung entspricht, mithilfe eines Fotolacks auf das vom GaN-basierten Epitaxie-Wafer abgewandte Ende der Substratschicht (2), und
Durchführen einer Metallsputterverdampfung an dem vom GaN-basierten Epitaxiewafer abgewandten Ende der Substratschicht (2) gemäß einer vorgegebenen Materialfolge und Abtragen von Metall an einer Stelle, die dem Gittermuster entspricht, um eine geätzte reflektierende Hintergrundbeleuchtungsschicht (1) zu erhalten.

4. Herstellungsverfahren für eine Vielzahl von Mini-LED-Chips vom Hintergrundbeleuchtungstyp gemäß Anspruch 3, wobei die vorgegebene Materialreihenfolge nacheinander Nickel, Silber, Nickel, Titan-Wolfram, Nickel und Titan-Wolfram ist.

5. Herstellungsverfahren für eine Vielzahl von Mini-LED-Chips vom Hintergrundbeleuchtungstyp gemäß Anspruch 3, wobei das Ausrichten einer Fotomaske und eines vorhandenen Musters des feinpolierten Wafers mittels eines Rückseitenausrichtungsverfahrens Folgendes umfasst:
Reservieren eines metallischen Ausrichtungsmusters, das von einer Rückseite des Wafers durch Reflexion sichtbar ist, auf einer Vorderseite des Wafers, und Durchführen einer Ausrichtung an der Photomaske und dem vorhandenen Muster des Wafers.

6. Verfahren zur Herstellung einer Vielzahl von Mini-LED-Chips vom Hintergrundbeleuchtungstyp gemäß Anspruch 1, wobei das Herstellungsverfahren vor dem Erhalten des Mini-LED-Chips mit dem Gitter (5) Folgendes umfasst:
Schneiden des Chips in einem voreingestellten Abstand und Anordnen der nach dem Schneiden erhaltenen Chips gemäß der vorgegebenen Anordnung.

7. Eine Vielzahl von Mini-LED-Chips vom Hintergrundbeleuchtungstyp mit einer vorgegebenen Anordnung von Mini-LED-Chips, die zwischen einer rechteckigen Matrix und einer rautenförmigen Matrix gewählt wird, wobei jeder Mini-LED-Chip vom Hintergrundbeleuchtungstyp aus der Vielzahl von Mini-LED-Chips vom Hintergrundbeleuchtungstyp eine rückseitige lichtabschirmende Reflexionsschicht, eine Substratschicht (2) und einen Flip-Chip (3) umfasst, wobei:
Die rückseitige lichtabschirmende Reflexionsschicht an einem Ende der Substratschicht (2) sich befindet; der Flip-Chip (3) an einem Ende der Substratschicht (2) sich befindet, das von der rückseitigen lichtabschirmenden Reflexionsschicht abgewandt ist;
Die rückseitige lichtabschirmende Reflexionsschicht ein Gitter (5) umfasst,
wobei, wenn die vorgegebene Anordnung der Mini-LED-Chips eine rechteckige Matrix ist, das Gitter (5) aus kreuzenden Linien besteht, die senkrecht zu den vier Kanten des Chips verlaufen und deren Schnittpunkt den Mittelpunkt des Chips bildet; oder das Gitter (5) ein quadratisches Gitter ist, dessen Mittelpunkt der Mittelpunkt des Chips ist;
Wenn die vorgegebene Anordnung der Mini-LED-Chips eine rhombische Matrix ist, besteht das Gitter (5) aus zwei Diagonalen des Chips; und
wobei der Abstand zwischen den Mini-LED-Chips 100 µm bis 15.000 µm beträgt; und die Breite des Gitters (5) 2 µm bis 200 µm beträgt.

## Revendications

1. Procédé de fabrication d'une pluralité de puces Mini LED de type rétroéclairage, dans lequel ladite pluralité de puces Mini LED de type rétroéclairage présente une disposition prédéfinie de puces Mini LED choisie parmi une matrice rectangulaire et une matrice rhombique ; ledit procédé comprenant :
graver, selon la disposition prédéfinie des puces Mini LED, un réseau (5) dont la forme correspond à ladite disposition prédéfinie sur une couche réfléchissante de rétroéclairage (1) de chaque puce Mini LED ; dans lequel le réseau (5) dont la forme correspond à la disposition prédéfinie comprend : si la disposition prédéfinie est une matrice rectangulaire, le réseau (5) est constitué de lignes croisées perpendiculaires aux quatre bords de la puce et dont le point d'intersection correspond au centre de la puce ; ou bien, le réseau (5) est un réseau carré dont le centre coïncide avec le centre de la puce ; si la disposition prédéfinie est une matrice rhombique, le réseau (5) est constitué de deux diagonales de la puce,
et ajuster le rapport entre la lumière émergente verticale et la lumière émergente latérale de chacune de ces puces par le réglage de la largeur du réseau (5), de manière à obtenir une puce Mini LED dotée de ce réseau.

2. Procédé de fabrication d'une pluralité de puces Mini LED de type rétroéclairage selon la revendication 1, dans lequel le réglage du rapport entre la lumière émise verticalement et la lumière émise latéralement par la puce, par ajustement de la largeur du réseau (5), comprend :
déterminer si la lumière émergente latérale de la puce est supérieure à la lumière émergente verticale de la puce ; si tel est le cas, augmenter la largeur du réseau (5) ; dans le cas contraire, diminuer la largeur du réseau (5).

3. Procédé de fabrication d'une pluralité de puces Mini LED de type rétroéclairage selon la revendication 1, dans lequel la gravure, selon une disposition prédéfinie des puces Mini LED, d'un réseau (5) dont la forme correspond à ladite disposition prédéfinie sur une couche réfléchissante de rétroéclairage (1) de chaque puce comprend :
la croissance d'une plaquette épitaxiale à base de GaN à une extrémité d'une couche de substrat (2) ;
usiner une puce à montage inversé (3) à une extrémité, opposée à la couche de substrat (2), de la plaquette épitaxiale à base de GaN afin d'obtenir une plaquette ; polir finement une extrémité de la couche de substrat (2) de la plaquette, opposée à la plaquette épitaxiale à base de GaN, et réaliser l'alignement sur un photomasque et un motif existant de la plaquette polie finement à l'aide d'une méthode d'alignement par la face arrière ;
réaliser l'exposition et le développement sur la plaquette ayant fait l'objet d'un alignement, et transférer, à l'aide d'un photorésist, un motif de réseau dont la forme correspond à la disposition prédéfinie, sur l'extrémité de la couche de substrat (2) opposée à la plaquette épitaxiale à base de GaN, et
réaliser une évaporation par pulvérisation métallique sur l'extrémité de la couche de substrat (2) opposée à la plaquette épitaxiale à base de GaN, selon une séquence de matériaux prédéfinie, puis retirer le métal à un emplacement correspondant au motif de réseau afin d'obtenir une couche réfléchissante de rétroéclairage gravée (1).

4. Procédé de fabrication d'une pluralité de puces Mini LED de type rétroéclairage selon la revendication 3, dans lequel la séquence de matériaux prédéfinie est, dans l'ordre : nickel, argent, nickel, titane-tungstène, nickel et titane-tungstène.

5. Procédé de fabrication d'une pluralité de puces Mini LED de type rétroéclairage selon la revendication 3, dans lequel l'alignement d'un photomasque et d'un motif existant de la plaquette finement polie au moyen d'un procédé d'alignement arrière comprend :
réserver, sur la face avant de la plaquette, un motif d'alignement métallique visible par réflexion depuis la face arrière de celle-ci, et effectuer l'alignement entre le photomasque et le motif existant sur la plaquette.

6. Procédé de fabrication d'une pluralité de puces Mini LED de type rétroéclairage selon la revendication 1, dans lequel, avant d'obtenir la puce Mini LED comportant le réseau (5), le procédé de fabrication comprend :
découper la puce selon un intervalle prédéfini, puis disposer les puces obtenues après découpe selon la disposition prédéfinie.

7. Ensemble de puces Mini LED de type rétroéclairage présentant une disposition prédéfinie de puces Mini LED choisie parmi une matrice rectangulaire et une matrice rhombique, dans lequel chaque puce Mini LED de type rétroéclairage de cet ensemble comprend une couche réfléchissante arrière faisant écran à la lumière, une couche de substrat (2) et une puce à montage inversé (3), dans lequel :
la couche réfléchissante arrière faisant écran à la lumière est située à une extrémité de la couche de substrat (2) ; la puce à montage inversé (3) est située à une extrémité de la couche de substrat (2), à l'opposé de la couche réfléchissante arrière faisant écran à la lumière ;
la couche réfléchissante arrière faisant écran à la lumière comprend un réseau (5),
dans lequel, si la disposition prédéfinie des puces Mini LED est une matrice rectangulaire, le réseau (5) est constitué de lignes croisées perpendiculaires aux quatre bords de la puce et dont le point d'intersection correspond au centre de la puce ; ou bien, le réseau (5) est un réseau carré dont le centre coïncide avec le centre de la puce ;
si la disposition prédéfinie des puces Mini LED est une matrice rhombique, le réseau (5) est constitué de deux lignes diagonales de la puce ; et dans lequel
l'espacement entre les puces Mini LED est compris entre 100 µm et 15 000 µm ; et la largeur du réseau (5) est comprise entre 2 µm et 200 µm.
